# EUROPÄISCHE PATENTSCHRIFT

(11) **EP 2 460 273 B1**
(45) Veröffentlichungstag und Bekanntmachung des Hinweises auf die Patenterteilung: **21.10.2015**
(21) Anmeldenummer: 10733013.6
(22) Anmeldetag: 20.07.2010
(51) Int. Cl.: H03K 17/96

(54) **SENSORELEMENTEINRICHTUNG UND VERFAHREN ZUR HERSTELLUNG EINES FORMKÖRPERS EINER SENSORELEMENTEINRICHTUNG**
SENSOR ELEMENT DEVICE AND METHOD FOR PRODUCING A MOLDED BODY OF A SENSOR ELEMENT DEVICE
DISPOSITIF À ÉLÉMENT DÉTECTEUR ET PROCÉDÉ DE FABRICATION D'UN CORPS DE FORME POUR UN DISPOSITIF À ÉLÉMENT DÉTECTEUR

(30) Priorität: 28.07.2009 DE 102009036161
(43) Veröffentlichungstag der Anmeldung: 06.06.2012
(73) Patentinhaber: E.G.O. Elektro-Gerätebau GmbH, 75038 Oberderdingen (DE)
(72) Erfinder: KLEINHANS, Andreas, 75031 Eppingen (DE)
(74) Vertreter: Patentanwälte Ruff, Wilhelm, Beier, Dauster & Partner mbB
(86) Internationale Anmeldenummer: PCT/EP2010/060488
(87) Internationale Veröffentlichungsnummer: WO 2011/012501

(56) Entgegenhaltungen:
- EP-A1- 1 257 057
- EP-A1- 1 672 283
- EP-A1- 2 043 407
- EP-A2- 1 672 797
- WO-A1-2004/107062
- WO-A1-2008/090887
- DE-A1-102004 040 998
- DE-A1-102006 022 965
- US-A- 5 917 165

## Beschreibung

### Anwendungsgebiet und Stand der Technik

Die Erfindung betrifft eine Bedieneinrichtung für einen kapazitiven Berührungsschalter einer ein Bedienfeld aufweisenden Bedieneinrichtung gemäß dem Oberbegriff des Anspruchs 1. Die Erfindung betrifft des weiteren ein Verfahren zur Herstellung eines Formkörpers einer Bedieneinrichtung.

Aus der DE 10 2004 040 998 A1 ist eine Anzeigeeinrichtung für ein Elektrogerät sowie ein Verfahren zur Herstellung einer solchen Anzeigeeinrichtung bekannt. Die Anzeigevorrichtung weist einen transparenten Formkörper auf, der größtenteils von einer lichtundurchlässigen Hülle umgeben ist. Die Hülle kann beispielsweise ein weiterer, becherartig ausgeformter Formkörper, oder ein Tauchlack sein. Der becherartige Formkörper bzw. der Lacküberzug weisen Unterbrechungen auf, deren Innenkonturen den Außenkonturen der mittels der Anzeigeeinrichtung darzustellenden Piktogrammen entsprechen.

Des Weiteren sind beispielsweise aus der DE 197 06 167 A1 kapazitive Berührungsschalter für Bedieneinrichtungen bekannt.

Aus der DE 10 2006 022 965 A1 ist eine Bedieneinrichtung mit einem kapazitiven Berührungsschalter bekannt, bei der auf einer Oberseite eines Lichtleiters eine elektrisch leitfähige Beschichtung bzw. Oberfläche vorhanden ist. Ein Leuchtmittel strahlt in den Lichtleiter ein zur Beleuchtung des Berührungsschalters. Über flanschartige Kontaktflächen an der Seite des Lichtleiters ist die elektrisch leitfähige Beschichtung auf der Oberseite des Lichtleiters mit einem Bauteilträger elektrisch verbunden. Aus der WO 2004/107062 A1 ist eine weitere Bedieneinrichtung mit einem kapazitiven Berührungsschalter bekannt. Das Sensorelement wird von einem elektrisch leitfähigen Flachmaterial gebildet, das in einem Bereich auf der Oberseite eines Lichtleiters aufliegt, der zusammen mit einem Leuchtmittel eine Leuchtanzeige bildet. Ein anderer Bereich des Flachmaterials liegt zur elektrischen Kontaktierung direkt auf einem Bauteilträger auf.

Aus der EP 1 672 283 A1 ist eine Anzeigeeinrichtung für ein Haushaltsgerät bekannt. Auf einem Bauteilträger ist eine LED angeordnet und mit einem Lichtverteilungselement umgeben. Dieses wiederum weist an seiner Außenseite eine Anzeigesymbolmaske auf. In dieser ist mit einem Laser eine Fehlstelle herausgearbeitet, die durchleuchtet wird und so ein Anzeigesymbol einer Leuchtanzeige bildet. Das Lichtverteilungselement ist mit Verbindungsstiften in Verbindungslöcher des Bauteilträgers eingesetzt.

### Aufgabe und Lösung

Die der Erfindung zugrundeliegende Aufgabe ist es, eine Bedieneinrichtung für einen kapazitiven Berührungsschalter bereitzustellen, die auch als Anzeigevorrichtung verwendet und einfach hergestellt werden kann, sowie auch ein genanntes Verfahren.

Gelöst wird diese Aufgabe durch eine Bedieneinrichtung mit den Merkmalen des Anspruchs 1 sowie durch ein Verfahren mit den Merkmalen des Anspruchs 7. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht. Manche der nachfolgenden, jedoch nicht erschöpfend aufgezählten Merkmale und Eigenschaften treffen sowohl auf die Bedieneinrichtung als auch auf das Verfahren zu. Sie werden teilweise nur einmal beschrieben, gelten jedoch unabhängig voneinander sowohl für die Bedieneinrichtung als auch für das Verfahren. Weiterhin ist die Reihenfolge der aufgelisteten Merkmale nicht bindend, sondern kann vielmehr entsprechend einer optimierten Bedieneinrichtung bzw. eines entsprechenden Verfahrens geändert werden.

Die Sensorelementeinrichtung der Bedieneinrichtung weist einen Formkörper aus einem elektrisch nicht leitenden Material auf, wobei der Formkörper eine im montierten Zustand an einer Unterseite des Bedienfeldes anliegenden Oberseite aufweist und wobei er in einer Richtung senkrecht zu seiner Oberseite zumindest abschnittsweise lichtdurchlässig und zusammen mit einem Leuchtmittel als Leuchtanzeige ausgebildet ist. Zumindest an seiner Oberseite ist er mit einer elektrisch leitfähigen und lichtundurchlässigen Beschichtung als kapazitives Sensorelement versehen.

Erfindungsgemäß weist eine entsprechende Bedieneinrichtung einen Formkörper aus einem elektrisch nicht leitenden Material auf mit der elektrisch leitfähigen Beschichtung. Diese elektrisch leitfähige Beschichtung weist wenigstens eine Ausnehmung auf, die im auf den Formkörper aufgebrachten Zustand mittels eines Lasers erzeugt wurde. Die genannten Bedieneinrichtungen, für die die Sensorelementeinrichtung vorgesehen ist, können beispielsweise Haushaltsgeräte, insbesondere Kochfelder, Backöfen und/oder Essen oder dergleichen sein. Im Wesentlichen ist die erfindungsgemäße Bedieneinrichtung für den Einsatz in allen Haushaltsgeräten denkbar, bei denen eine im Wesentlichen beliebige Eingabe von Parametern und/oder Ausgabe von Informationen einer Bedienperson vorgesehen ist. Die grundsätzliche Funktion von kapazitiven Berührungsschaltern, die selbstverständlich auch kapazitive Näherungsschalter sein können, ist beispielsweise aus der DE 197 06 167 A1 bekannt, so dass hier auf eine genaue Erläuterung verzichtet wird. Vorteilhaft bildet der Formkörper zusammen mit dem Leuchtmittel eine Leuchtanzeige, wobei besonders vorteilhaft pro Leuchtanzeige nur ein Leuchtmittel vorgesehen ist und sie insbesondere ein Bauteil bzw. eine Baueinheit ist.

Das elektrisch nicht leitende Material, aus dem der Formkörper hergestellt ist, kann beispielsweise ein Kunststoff, eine Keramik oder dergleichen sein. Die zumindest abschnittsweise Lichtdurchlässigkeit des Formkörpers kann dadurch erzeugt werden, dass der Formkörper mit einem Bereich versehen ist, der beispielsweise aus transparentem Kunststoff hergestellt ist. Dieser Bereich kann eine im Wesentlichen beliebige Kontur aufweisen, beispielsweise eine der Außenkontur des Formkörpers ähnelnde Kontur. Aber auch eine Kontur, die der mittels der Leuchtanzeige anzuzeigenden Darstellung entspricht, ist möglich. Schließlich ist noch denkbar, dass der Formkörper vollständig aus lichtdurchlässigem Material hergestellt und beispielsweise maskiert ist.

Die elektrisch leitfähige Beschichtung kann in einem im Wesentlichen beliebigen Verfahren auf den Formkörper aufgebracht werden. Beispielhaft werden hier Besprühen, Eintauchen, Aufdampfen oder Abscheiden genannt. Vorzugsweise ist die Beschichtung wenigstens vorübergehend bis zum Ausbrennen beziehungsweise Erzeugen der Ausnehmung mittels des Lasers und zumindest in den Bereichen der Oberseite des Formkörpers vorgesehen, die lichtdurchlässig ausgebildet sind.

Die mittels des Lasers erzeugten Ausnehmungen, die in die Beschichtung eingebracht werden, dienen dazu, die mittels der Leuchtanzeige darzustellenden Symbole beziehungsweise Piktogramme oder dergleichen anzuzeigen. Die Ausnehmungen sind dabei vorteilhaft lediglich in die Beschichtung eingebracht beziehungsweise darin vorgesehen. Je nach zu erzielendem Effekt können sich die Ausnehmungen auch bis in den Formkörper hinein erstrecken. Auf diese Weise könnte beispielsweise durch eine gezielt oder zufällig erzeugte Beschaffenheit der Oberfläche des Formkörpers im Bereich der Ausnehmung ein besonderes Streumuster der Lichtanzeige erreicht werden. Normalerweise wird die Ausnehmung jedoch nur in die Beschichtung alleine eingebracht, insbesondere eingebrannt.

Durch die Verwendung einer elektrisch leitfähigen Beschichtung, die auf einem elektrisch nicht leitfähigen Formkörper aufgebracht wird, wird vorteilhaft erreicht, dass ein einziger standardisierter Formkörper mit dem hier beschriebenen Sensorelement, oder aber auch ohne Sensorwirkung verwendet werden kann. Mit Laser werden die Ausnehmungen mittels eines gut beherrschten, einfach zu reproduzierenden sowie an sich ändernde Gegebenheiten einfach zu adaptierenden Bearbeitungsverfahrens für die Herstellung der Leuchtanzeige in die Beschichtung eingebracht.

Es versteht sich, dass der Formkörper beziehungsweise die Sensorelementeinrichtung im Bereich eines im Wesentlichen beliebigen Leuchtmittels angeordnet ist und/oder Ausnehmungen für die Aufnahme von Leuchtmitteln aufweist. Die Leuchtmittel dienen zumindest als Lichtquelle der Leuchtanzeige.

In einer Ausgestaltung der Erfindung ist die Beschichtung ein sogenannter Leitlack. Ein Leitlack ist beispielsweise eine Suspension mit Partikeln von Kupfer, Silber, Zink, Grafit oder dergleichen. Der Leitlack kann beispielsweise auf den Formkörper aufgesprüht oder in einem Tauchlackverfahren aufgebracht werden.

Bei der Erfindung ist die Beschichtung lichtundurchlässig. Auf diese Weise wird erreicht, dass lediglich die mittels des Lasers erzeugten Ausnehmungen als leuchtender Bereich der Leuchtanzeige erkennbar sind, insbesondere als entsprechendes Symbol oder Piktogramm.

Bei der Erfindung ist an dem Formkörper wenigstens ein elektrisch leitendes, stiftartiges Bauteil eingearbeitet, wobei das stiftartige Bauteil die Beschichtung elektrisch mit einem Bauteilträger verbindet, insbesondere mit einer elektrischen bzw. elektronischen Schaltung. Bevorzugt sind zwei, drei bzw. vier stiftartige Bauteile an dem Formkörper vorgesehen, die regelmäßige beziehungsweise unregelmäßige Muster bilden, beispielsweise in Eckbereichen und/oder in Bereichen von Seitenkanten. Die stiftartigen Bauteile stehen direkt und/oder indirekt mit der Beschichtung in elektrischem Kontakt. Des Weiteren dienen diese stiftartigen Bauteile zum einen als Fixierung der Sensorelementeinrichtung an einem Bauteilträger sowie zum anderen zum Kontaktieren der Beschichtung, die ja ein kapazitives Sensorelement darstellt, mit dem Bauteilträger. Die stiftartigen Bauteile können hierzu in Ausnehmungen im Bauteilträger angeordnet werden. Alternativ können sie einteilig mit dem Formkörper und/oder dem Bauteilkörper hergestellt sein, beispielsweise gespritzt. Bei entsprechender Anordnung der Ausnehmungen können diese im Zusammenwirken mit den stiftartigen Bauteilen auch eine Formcodierung darstellen. Mittels der Formcodierungen kann gewährleistet werden, dass die Sensorelementeinrichtungen in nur einer einzigen Orientierung relativ zum Bauteilträger daran angeordnet werden können.

Die Ausnehmungen im Bauteilträger können eine elektrisch leitfähige Beschichtung aufweisen, so dass die stiftartigen Bauteile steckkontaktartig mit dem Bauteilträger verbunden sind. Es ist hierzu vorstellbar, dass die stiftartigen Bauteile zusätzlich entsprechend ausgebildete, federartige Abschnitte oder dergleichen aufweisen, um beispielsweise eine Klemmwirkung in den Ausnehmungen zu erzielen. Alternativ hierzu können die stiftartigen Bauteile wie bei jedem beliebigen anderen elektronischen Bauteil als sogenannte Lötfahnen zusätzlich mit dem Bauteilträger verlötet und/oder mit elektrisch leitfähigem Kleber verklebt werden.

In einer Alternative zu der Erfindung ist an dem Formkörper zumindest ein elektrisch nicht leitendes, stiftartiges Bauteil vorgesehen, das ebenfalls zumindest teilweise mit einer elektrisch leitfähigen Beschichtung versehen ist. Die auf dem Formkörper aufgebrachte Beschichtung ist mit dieser Beschichtung auf dem stiftartigen Bauteil verbunden, insbesondere indem die Beschichtung den Formkörper und das stiftartige Bauteil im Wesentlichen vollständig überzieht. Ein vollständiger Überzug ist beispielsweise in einfacher Weise erreichbar, indem die Beschichtung mittels eines Tauchverfahrens auf den Formkörper aufgebracht wird. Die elektrische Verbindung des kapazitiven Sensorelementes, nämlich der Beschichtung auf den Formkörper, mit dem Bauteilträger, kann dann gemäß vorstehender Beschreibung erfolgen.

In weiterer Ausgestaltung der Erfindung weist die Ausnehmung die Form eines Piktogrammes und/oder wenigstens einer Ziffer auf. Auf diese Weise kann einer Bedienperson die Funktion des jeweiligen Bedienteils dargestellt werden.

In Ausgestaltung der Erfindung weist der Formkörper einen lichtdurchlässigen Innenbereich auf, der sich vorteilhaft senkrecht zur beschichteten Oberseite erstreckt, wobei dieser Innenbereich vorzugsweise von einem lichtundurchlässigen Bereich umgeben ist. Alternativ kann vorgesehen sein, dass der Formkörper vollständig lichtdurchlässig ist und an seiner Oberseite sowie an seiner senkrecht zur Oberseite verlaufenden Seite die Beschichtung aufweist, die zumindest im Seitenbereich des Formkörpers lichtundurchlässig ist. Es kann also ein homogen einstückig ausgebildeter Formkörper verwendet werden, also ein Formkörper, der lediglich aus einem Material hergestellt ist, oder ein einstückig inhomogener Formkörper. Als inhomogen wird hier verstanden, das die Eigenschaften desjenigen Materials, das für den Innenbereich des Formkörpers verwendet wird, die sich in mindestens einer Hinsicht von den Eigenschaften desjenigen Materials unterscheiden, das für den Bereich vorgesehen ist, der den Innenbereich des Formkörpers umgibt.

Die Lichtundurchlässigkeit ist hier vorgesehen, damit kein seitliches Streulicht aus den Seitenbereichen des Formkörpers austritt, sondern lediglich aus den für die Darstellung der mittels der Sensorelementeinrichtung zu steuernden Funktion vorgesehenen Ausnehmungen bzw. Piktogrammen.

Das der Erfindung zugrunde liegende Problem wird außerdem durch ein Verfahren zur Herstellung eines Formkörpers einer Sensorelementeinrichtung gelöst, das den Schritt des Urformens des Formkörpers aufweist, den Schritt des Aufbringens einer Beschichtung an einer Oberseite des Formkörpers den Schritt des Erzeugens einer Ausnehmung in der Beschichtung mittels eines Lasers, sowie den Schritt des zumindest abschnittsweise Einarbeitens eines elektrisch leitenden, stiftartigen Bauteils in den Formkörper zum Verbinden der Beschichtung mit einem Bauteilträger.

### Kurzbeschreibung der Zeichnungen

Ausführungsbeispiele der Erfindung sind in den Zeichnungen schematisch dargestellt und werden im Folgenden näher erläutert. Die in den einzelnen Figuren gezeigten Ausführungsformen weisen teilweise Merkmale auf, die die anderen dargestellten Ausführungsformen der Erfindung nicht aufweisen. Die Merkmale können jedoch, ohne den Rahmen der Erfindung zu verlassen, beliebig miteinander kombiniert werden. In den Zeichnungen zeigen:
- Fig.1: eine isometrische Ansicht einer Sensorelementeinrichtung gemäß einer ersten Ausführungsform,
- Fig.2: eine isometrische Ansicht einer Sensorelementeinrichtung gemäß einer zweiten Ausführungsform,
- Fig.3a: eine geschnittene Seitenansicht einer Sensorelementeinrichtung gemäß einer dritten Ausführungsform eingebaut in einer Bedieneinrichtung eines Haushaltsgerätes,
- Fig.3b - Fig.4b: geschnittene Seitenansichten einer Sensorelementeinrichtung gemäß einer vierten bis sechsten Ausführungsform, jeweils eingebaut in einer Bedieneinrichtung eines Haushaltsgerätes.

### Detaillierte Beschreibung der Ausführungsbeispiele

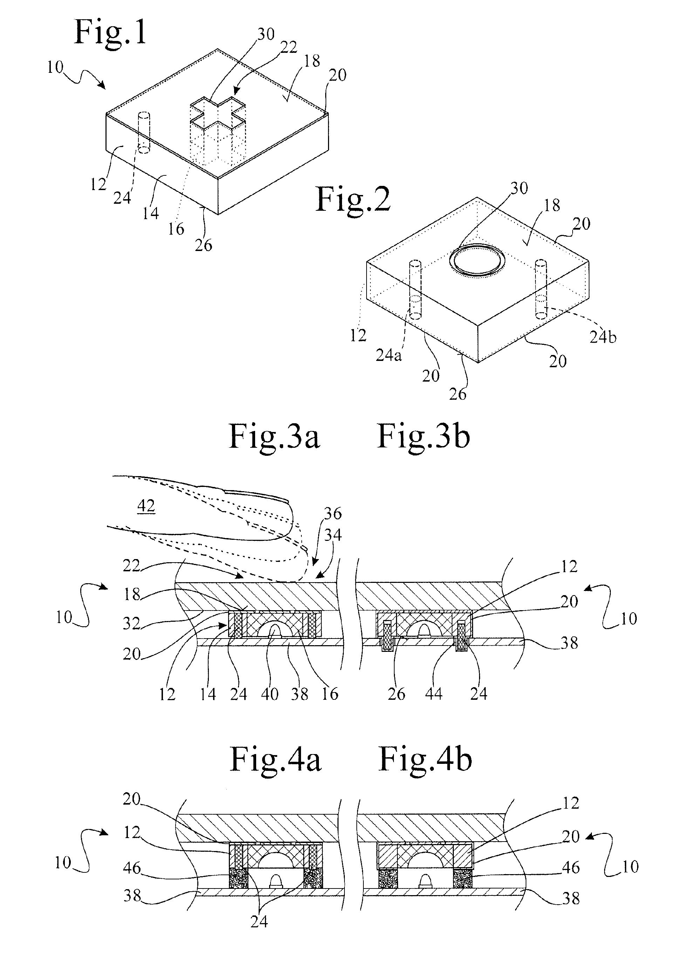

In Fig. 1 ist eine Sensorelementeinrichtung 10 gezeigt, die einen Formkörper 12 aufweist. Der Formkörper 12 ist im Wesentlichen zweiteilig aufgebaut. Er weist einen Außenbereich 14 auf, der einen Innenbereich 16 umgibt, wobei der Außenbereich 14 lichtundurchlässig und der Innen-bereich 16 lichtdurchlässig ausgebildet ist. Sowohl Außenbereich 14 als auch Innenbereich 16 sind aus Kunststoff gefertigt. Der Innenbereich 16 weist eine kreuzförmige Außenkontur auf, die in der Verwendung der Sensorelementeinrichtung als Leuchtanzeige als Plus-Symbol erkennbar ist. Der Formkörper 12 weist an seiner Oberseite 18 eine Beschichtung 20 auf, die den Außenbereich 14 vollständig bedeckt. Die Beschichtung 20 ist elektrisch leitfähig. Der Formkörper 12 ist im Außenbereich 14 von einem elektrisch leitenden, stiftartigen Bauteil 24 so durchsetzt, dass das stiftartige Bauteil 24 die Beschichtung 20 von einer Unterseite 26 des Formkörpers 12 ausgehend elektrisch kontaktierbar macht.

Die Beschichtung 20 weist oberhalb des Innenbereiches 16 eine Ausnehmung 30 mit einer dem Innenbereich 16 entsprechenden Innenkontur auf. Die Ausnehmung 30 wurde mittels eines nicht dargestellten Lasers aus einer ursprünglich im Wesentlichen vollflächig auf dem Formkörper 12 aufgebrachten Beschichtung 20 erzeugt beziehungsweise heraus gebrannt.

Im Unterschied zu Fig. 1 ist in Fig. 2 der Formkörper 12 einstückig, also ohne Innenbereich bzw. Außenbereich ausgebildet. Der Formkörper 12 ist vollständig, also an jeder Außenseite, mit der Beschichtung 20 versehen, die als Leitlack ausgebildet ist. Dieser Leitlack wurde in einem Tauchlackierverfahren aufgebracht. Im Anschluss an das Lackierverfahren, also nach dem Trocknen des Lackes, wurde im Bereich der Oberseite 18 des Formkörpers 12 eine kreisringförmige Ausnehmung 30 in die Beschichtung erzeugt. Dies wurde wiederum mittels eines nicht dargestellten Lasers vorgenommen.

Als weiterer Unterschied der Fig. 2 zu Fig. 1 ist die Art und Anzahl der vorgesehenen stiftartigen Bauelemente 24a, 24b zu erkennen. Die stiftartigen Bauelemente 24a, 24b sind gemäß Fig. 2 aus einem elektrisch nicht leitenden Material hergestellt. Allerdings sind die stiftartigen Bauteile 24a, 24b ebenfalls von der Beschichtung 20 überzogen. Des Weiteren ragen die stiftartigen Bauteile 24a, 24b über die Unterseite 26 des Formkörpers 12 heraus. Auf diese Weise können sie mit einem in Fig. 2 nicht dargestellten Bauteilträger, beispielsweise einer Leiterplatte oder dergleichen, wie von anderen elektrischen und/oder elektronischen Bauteilen bekannt, verbunden werden, beispielsweise durch Einstecken in elektrisch leitfähig beschichtete Ausnehmungen.

Es ist anzumerken, dass die Form, Lage sowie die sonstige Ausgestaltung der stiftartigen Bauteile im Wesentlichen beliebig gewählt werden kann. Wie sich nachfolgend noch ergeben wird, sind die stiftartigen Bauteile 24 so anzuordnen und mit entsprechenden Abmessungen zu wählen, dass die Sensorelementeinrichtung 10 an einem in den Fig. 1 und 2 nicht dargestellten Bauteilträger befestigt werden kann und/oder dass die elektrisch leitfähige Beschichtung 20 mit einer elektrischen bzw. elektronischen Schaltung verbunden werden kann.

Die in Fig. 3a dargestellte Sensorelementeinrichtung 10 ist an einer Unterseite 32 eines Bedienfeldes 34 einer Bedieneinrichtung 36 angeordnet. Die Sensorelementeinrichtung 10 weist einen Formkörper 12 bestehend aus einem Außenbereich 14 sowie einem Innenbereich 16 auf. Der Außenbereich 14 ist von stiftartigen Bauteilen 24 so durchsetzt, dass diese die Beschichtung 20 an der Oberseite 18 des Formkörpers 12 mit einem Bauteilträger 38 verbinden. Auf der dem Formkörper 12 zugewandten Seite des Bauteilträgers 38 ist ein als LED ausgebildetes Leuchtmittel 40 zur Beleuchtung der Leuchtanzeige 22 angeordnet. Gemäß Fig. 3a ist die Beschichtung 20 der Sensorelementeinrichtung 10 mittels der Stifte 24 mit dem Bauteilträger 38 elektrisch verbunden. Die Sensorelementeinrichtung 10 ist so am Bedienfeld angeordnet, dass die Beschichtung 20 als kapazitives Sensorelement eines kapazitiven Berührungsschalters bzw. eines kapazitiven Näherungsschalters verwendet werden kann. Der Berührungs- bzw. Näherungsschalter ist in bekannter Weise beispielsweise mittels eines Fingers 42 oder dergleichen einer Bedienperson bedienbar und der Status des Berührungs- bzw. Näherungsschalters wird mittels einer elektronischen bzw. elektrischen Schaltung ausgewertet, die beispielsweise auf dem Bauteilträger 38 angeordnet ist.

Die in Fig. 3b dargestellte Sensorelementeinrichtung 10 ist im Unterschied zur Sensorelementeinrichtung 10 der Fig. 3a im Wesentlichen vollständig von einer Beschichtung 20 eingehüllt. Die Beschichtung 20 erstreckt sich auch über die stiftartigen Bauteile 24, die im Unterschied zu den stiftartigen Bauteilen 24 der Fig. 3a gemäß Fig. 3b deutlich über die Unterseite 26 des Formkörpers 12 herausragen. Auf diese Weise können die stiftartigen Bauteile 24 in Ausnehmungen 44 im Bauteilträger 38 eingebracht werden, die elektrisch leitfähig beschichtet sind, beispielsweise mit dem Kupfer des Bauteilträgers. Die stiftartigen Bauteile 24, insbesondere jedoch die Beschichtung 20 darauf, ermöglicht eine elektrische Kontaktierung des Sensorelements mit dem Bauteilträger 38 bzw. einer auf dem Bauteilträger aufgebrachten elektrischen Schaltung. Die stiftartigen Bauteile 24 können auch vorteilhaft einteilig am Formkörper angespritzt sein.

Im Unterschied zu den Fig. 3a und 3b liegt die Sensorelementeinrichtung 10 in den Fig. 4a und 4b nicht direkt auf dem Bauteilträger 38 auf. Vielmehr ist die Sensorelementeinrichtung 10, insbesondere der Formkörper 12 einschließlich der Beschichtung 20, auf einem schaumgummiartigen Ring 46 angeordnet. Der schaumgummiartige Ring ist elektrisch leitend ausgebildet und lichtundurchlässig. Auf diese Weise bildet der schaumgummiartige Ring 46 eine elektrische Verbindung zwischen den stiftartigen Bauteilen 24 bzw. der Beschichtung 20 und dem Bauteilträger 38. Außerdem unterbindet der schaumgummiartige Ring 46 zur Seite austretendes Streulicht. Ein solcher Ring ist in der deutschen Patentanmeldung DE 10 2009 036 162 A beschrieben, auf die diesbezüglich explizit verwiesen wird.

## Patentansprüche

1. Bedieneinrichtung (36) mit einem Bedienfeld (34) und einer Sensorelementeinrichtung mit einem kapazitiven Berührungsschalter, wobei die Sensorelementeinrichtung (10) einen Formkörper (12) aus einem elektrisch nicht leitenden Material aufweist, wobei eine Oberseite (18) des Formkörpers (12) geeignet ausgebildet ist, um im montierten Zustand an einer Unterseite (32) des Bedienfeldes (34) anzuliegen, wobei der Formkörper (12) in einer Richtung senkrecht zu seiner Oberseite (18) zumindest abschnittsweise lichtdurchlässig und zusammen mit einem Leuchtmittel (40) als mittels Lichtdurchtritt wahrnehmbare Leuchtanzeige (22) ausgebildet ist und wobei der Formkörper (12) zumindest an seiner Oberseite (18) mit einer elektrisch leitfähigen und lichtundurchlässigen Beschichtung (20) als kapazitives Sensorelement versehen ist, **dadurch gekennzeichnet, dass** die zumindest auf der Oberseite des Formkörpers (12) aufgetragene elektrisch leitfähige und lichtundurchlässige Beschichtung (20) wenigstens eine Ausnehmung (30) aufweist, wobei in den Formkörper (12) wenigstens ein elektrisch leitendes, stiftartiges Bauteil (24) zumindest abschnittsweise eingearbeitet ist, das die Beschichtung (20) elektrisch mit einem Bauteilträger (38) verbindet.

2. Bedieneinrichtung nach Anspruch 1, **dadurch gekennzeichnet, dass** die Beschichtung (20) ein so genannter Leitlack ist.

3. Bedieneinrichtung nach Anspruch 1 oder 2, **dadurch gekennzeichnet, dass** das stiftartige Bauteil (24) die Beschichtung (20) mit einer elektrischen beziehungsweise elektronischen Schaltung verbindet.

4. Bedieneinrichtung nach Anspruch 1, **dadurch gekennzeichnet, dass** die Ausnehmung (30) die Form eines Piktogramms und/oder wenigstens einer Ziffer aufweist.

5. Bedieneinrichtung nach einem der vorstehenden Ansprüche, **dadurch gekennzeichnet, dass** der Formkörper (12) einen lichtdurchlässigen Innenbereich (16) aufweist, der sich senkrecht zur beschichteten Oberseite (18) erstreckt, wobei der Innenbereich (16) von einem lichtundurchlässigen Bereich (14) umgeben ist.

6. Bedieneinrichtung nach einem der Ansprüche 1 bis 4, **dadurch gekennzeichnet, dass** der Formkörper (12) vollständig lichtdurchlässig ist und an seiner Oberseite (18) sowie an seinen senkrecht zur Oberseite (18) verlaufenden Seiten die Beschichtung (20) aufweist, die zumindest im Seitenbereich lichtundurchlässig ist.

7. Verfahren zur Herstellung eines Formkörpers (12) einer Bedieneinrichtung (36) nach einem der vorstehenden Ansprüche mit den Schritten
• Urformen des Formkörpers (12)
• Aufbringen einer Beschichtung (20) an einer Oberseite (18) des Formkörpers (12) **gekennzeichnet durch**
• Erzeugen einer Ausnehmung (30) in der Beschichtung (20) mittels eines Lasers sowie
∘ zumindest abschnittsweise Einarbeiten eines elektrisch leitenden, stiftartigen Bauteils (24) in den Formkörper (12) zum Verbinden der Beschichtung (20) mit einem Bauteilträger (38).

## Claims

1. An operator control device (36) having a control panel (34) and a sensor element device having a capacitive contact switch, the sensor element device (10) having a molded body (12) made of an electrically non-conducting material, an upper side (18) of the molded body (12) being configured to rest against an underside (32) of the control panel (34) in the assembled state, the molded body (12) being formed at least in certain portions in a direction perpendicular to its upper side (18) to be transparent and together with an illuminant (40) form an illuminated indicator (22) perceptible by light transmission, and the molded body (12) being provided at least on its upper side (18) with an electrically conductive and opaque coating (20) as a capacitive sensor element, **characterized in that** the electrically conductive and opaque coating (20) applied at least on the upper side of the molded body (12) has at least one recess (30), the molded body (12) has at least one electrically conducting, pin-like component (24) incorporated at least in certain portions, said pin-like component electrically connecting the coating (20) to a component carrier (38).

2. The operator control device according to claim 1, **characterized in that** the coating (20) is a so-called conductive lacquer.

3. The operator control device according to claim 1 or 2, **characterized in that** the pin-like component (24) connects the coating (20) to an electrical or electronic circuit.

4. The operator control device according to claim 1, **characterized in that** the recess (30) has the form of a pictogram and/or at least one numeral.

5. The operator control device according to any one of the preceding claims, **characterized in that** the molded body (12) has a transparent inner region (16), which extends perpendicularly in relation to the coated upper side (18), the inner region (16) being surrounded by an opaque region (14).

6. The operator control device according to any one of claims 1 to 4, **characterized in that** the molded body (12) is completely transparent and has the coating (20) on its upper side (18) and on its sides extending perpendicularly in relation to the upper side (18), said coating being opaque at least in the side region.

7. A method for producing a molded body (12) of an operator control device (36) according to any one of the preceding claims, with the steps of
• initially forming the molded body (12),
• applying a coating (20) to an upper side (18) of the molded body (12), **characterized by**
• producing a recess (30) in the coating (20) by means of a laser and
• at least in certain portions incorporating an electrically conducting, pin-like component (24) in the molded body (12) for connecting the coating (20) to a component carrier (38).

## Revendications

1. Dispositif de commande (36) doté d'un panneau de commande (34) et d'un dispositif à éléments de détection présentant un commutateur capacitif de contact,
le dispositif (10) à éléments de détection présentant un corps moulé (12) en un matériau électriquement non conducteur,
un côté supérieur (18) du corps moulé (12) étant configuré de manière à pouvoir à l'état monté être placé sur le côté inférieur (32) du panneau de commande (34),
au moins certaines parties du corps moulé (12) étant transparentes à la lumière dans une direction perpendiculaire à son côté supérieur (18),
le corps moulé étant configuré avec un moyen d'éclairage (40) comme affichage lumineux (22) détectable par traversée de lumière,
le corps moulé (12) étant doté au moins sur son côté supérieur (18) d'un revêtement (20) électriquement conducteur et opaque servant d'élément de détection capacitif,
**caractérisé en ce que**
le revêtement (20) électriquement conducteur et opaque appliqué au moins sur le côté supérieur du corps moulé (12) présente au moins une découpe (30),
**en ce qu'**au moins un composant (24) électriquement conducteur en forme de tige est incorporé au moins en partie dans le corps moulé (12) et relie électriquement le revêtement (20) à un support (38) du composant.

2. Dispositif de commande selon la revendication 1, **caractérisé en ce que** le revêtement (20) est un vernis dit conducteur.

3. Dispositif de commande selon les revendications 1 ou 2, **caractérisé en ce que** le composant (24) en forme de tige relie le revêtement (20) à un circuit électrique ou électronique.

4. Dispositif de commande selon la revendication 1, **caractérisé en ce que** la découpe (30) présente la forme d'un pictogramme et/ou d'au moins un chiffre.

5. Dispositif de commande selon l'une des revendications précédentes, **caractérisé en ce que** le corps moulé (12) présente une partie intérieure (16) transparente qui s'étend perpendiculairement au côté supérieur revêtu (18), la partie intérieure (16) étant entourée par une partie opaque (14).

6. Dispositif de commande selon l'une des revendications 1 à 4, **caractérisé en ce que** le corps moulé (12) est entièrement transparent et **en ce que** le revêtement (20) présent sur son côté supérieur (18) ainsi que sur ses côtés qui s'étendent perpendiculairement à son côté supérieur (18) est opaque au moins dans la partie latérale.

7. Procédé de fabrication d'un corps moulé (12) pour un dispositif de commande selon l'une des revendications précédentes, le procédé présentant les étapes qui consistent à :
façonner le corps moulé (12),
appliquer un revêtement (20) sur un côté supérieur (18) du corps moulé (12),
**caractérisé par** l'étape qui consiste à
former au moyen d'un laser une découpe (30) dans le revêtement (20) et
incorporer au moins en partie un composant électriquement conducteur (24) en forme de tige dans le corps moulé (12) pour relier le revêtement (20) à un support (38) du composant.
